Europäisches Patentamt

European Patent Office

Office européen des brevets

(11) Publication number: **0 171 509 B1**

(12) **EUROPEAN PATENT SPECIFICATION**

(45) Date of publication of patent specification: **31.10.90**

(51) Int. Cl.⁵: **H 01 L 21/268,** H 01 L 21/263

(21) Application number: **85104750.6**

(22) Date of filing: **23.07.80**

(80) Publication number of the earlier application in accordance with Art. 76 EPC: **0 032 510**

(54) Silicon on sapphire laser process.

(30) Priority: **24.07.79 US 60081**

(43) Date of publication of application:
**19.02.86 Bulletin 86/08**

(45) Publication of the grant of the patent:
**31.10.90 Bulletin 90/44**

(84) Designated Contracting States:
**DE FR GB NL**

(56) References cited:
**DE-A-2 848 333**
**US-A-4 155 779**

**IBM TECHNICAL DISCLOSURE BULLETIN, vol. 19, no. 11, April 1977, pages 4438-4440, New York, US; P.S. HO et al.: "Multibeam method for growing large-grain semiconductor films"**

**APPLIED PHYSICS LETTERS, vol. 34, no. 12, 15th June 1979, pages 831-833, American Institute of Physics, New York, US; J.F. GIBBONS et al.: "CW Laser recrystallization of 100rSi on amorphous substrates"**

(73) Proprietor: **Hughes Aircraft Company**
**7200 Hughes Terrace P.O. Box 45066**
**Los Angeles, California 90045-0066 (US)**

(72) Inventor: **Yaron, Giora**
**19857 Beekman Place**
**Cupertino California 95014 (US)**
Inventor: **Harari, Elihahou**
**2320 Friars Lane**
**Los Altos California 94022 (US)**
Inventor: **Wang, Samuel T.**
**24052 Saleno Lane**
**Mission Viejo California 92675 (US)**
Inventor: **Hess, LaVerne D.**
**1462 Dorset**
**Thousand Oaks California 91360 (US)**

(74) Representative: **Crawford, Andrew Birkby et al**
**A.A. THORNTON & CO. Northumberland House**
**303-306 High Holborn**
**London WC1V 7LE (GB)**

(56) References cited:
ELECTRONICS LETTERS, vol. 15, no. 14, 5th July 1979, pages 435-437, New York, US; A.F. TASCH et al.: "Silicon-on-insulator MOSFETS fabricated on laser-annealed polysilicon on SiO2"

APPLIED PHYSICS LETTERS, vol. 28, no. 9, 1st May 1976, pages 538,539, American Institute of Physics, New York, US; J.M. HOFFMAN et al.: "High-power UV noble-gas-halide lasers"

EXTENDED ABSTRACTS OF THE JOURNAL OF THE ELECTROCHEMICAL SOCIETY, vol. 79-2, 14th-19th October 1979, Fall meeting; Princeton, New Jersey, US, pages 866-867,

abstract no. 335; G. YARON et al.: "Application of laser annealing to silicon on sapphire processing"

## Description

This invention is related to metal oxide semiconductor devices formed in silicon on sapphire in which the channel mobility is increased.

It is well known in the art that the speed of metal oxide semiconductor (MOS) devices may be increased by forming each individual MOS field effect transistor (FET) in a silicon island on a sapphire substrate which is isolated from other MOSFET's. Fabrication of such silicon on sapphire (SOS) devices is accomplished by growing epitaxial silicon on a sapphire substrate and then etching the silicon to form individual islands on which individual MOSFETS may be fabricated. A significant problem in the art of silicon on sapphire (SOS) is the low channel mobility which results from a high defect density at the top epitaxial silicon surface. Reduction in channel mobility decreases the device operating speed.

Another problem is that aluminium conductors interconnecting between individual MOSFETS on the sapphire substrate must cover a nearly vertical step formed at the edge of each silicon island. A reduction in the thickness of the deposited aluminium conductor and cracks in the aluminium may occur in the vicinity of a vertical step. Such cracks and reduction in the thickness of the deposited aluminium increases the likelihood of discontinuities in the aluminium conductor which cause device failure.

Another problem which is peculiar to SOS devices is that growth of a silicon dioxide layer over the silicon island usually is accompanied by a region of reduced oxide thickness resulting in a "V"-shaped groove at the lower corner of each silicon island edge. If a polycrystalline silicon conductive layer is deposited or grown thereover, the amount of insulation between the overlying polysilicon conductor and the silicon island is greatly reduced at the V-shaped groove, thereby increasing the likelihood of breakdown conduction through the insulating oxide film between the polysilicon conductor and the silicon island.

All of the foregoing problems may be solved in the present invention, in which a beam of radiant energy such as a laser beam is applied to the silicon island before formation of the overlying insulating and conducting layers. The energy and power density of the beam are sufficient to melt of the top epitaxial silicon layer, with a concommitant enhancement of channel mobility. Carrier mobility in thin surface regions of a given area of semicondutor material is improved by rapidly heating the surface area to or slightly above the melting point of the semiconductor material and then allowing the material to rapidly cool below its melting point in the recrystallisation process. Significantly, this in turn leads to an increase in the speed of transistors formed in the silicon. The exposure to a laser beam also causes the material in the silicon island edge to reflow, resulting in a reduction in the slope of the silicon island edge. The face of the silicon island edge becomes smoother during this reflow process, so that the roughness of the face is eliminated to provide a smooth and gradually sloping step.

A significant result of the use of this process is that oxide film overlying the silicon island has a uniform thickness even in the vicinity of the bottom edge corner of the silicon island. The uniform thickness of the oxide film provides uniform insulation between an overlying polysilicon conductor and the silicon island, thereby eliminating the problem of breakdown conduction at the bottom edge corner of the silicon island.

It is known to perform laser annealing on silicon islands to increase the grain size in the crystal structure. Examples of such a process are disclosed in (1) Electronics Letters, Vol. 15, No. 14, 5th July 1979. pp. 435-437 "Silicon-on-insulator MOSFETS fabricated on laser-annealed polysilicon on Sio$_2$" and (2) Applied Physics Letters Vol. 34, No. 12, 15th June 1979, pp.831-833 "CW laser recrystallisation of (100) Si on amorphous substrates". Also, the use of pulsed laser beams to smooth the edges of silicon islands on sapphire and achieve lower polysilicon sheet resistivity is disclosed in (3) RCA Review, Vol. 40, 1979, pp. 339-344" Laser Annealing to Round the Edges of Silicon Structures".

The present invention provides a method for increasing channel carrier mobility in a surface region of a silicon island formed on a sapphire substrate comprising irradiating a predetermined surface area of the silicon island with a pulsed radiation beam of a chosen wavelength, pulse duration and energy per unit area sufficient to elevate the temperature of only a thin surface layer bounded by said surface area to the melting point of the silicon, and thereafter allowing the silicon to cool below its melting point while recrystallizing to solid state.

It should be noted that, if high temperature furnace processing were used in an attempt to avoid the foregoing problems, high leakage currents at the silicon-sapphire interface between the source and the drain of the MOS transistor would occur. Such problems are avoided in this invention by applying a laser beam of sufficiently short wavelength and pulse duration so that the radiation is absorbed within a thin surface layer and over a time period shorter than the characteristic longitudinal thermal transport time of the silicon island. In the preferred embodiment of the invention, the silicon islands are exposed to radiation from an excimer laser emitting radiation having a wavelength of 2490 A, a pulse duration of 25 nanoseconds, a beam size in the range of 0.1 to 0.2 cm$^2$ and an energy density in the range of 0.5 to 1.0 joules/cm$^2$. Alternatively, a pulsed ion beam or electron beam source may be used in a similar fashion.

Following application of the laser beam, the roughness on the edge face of each island has been found to disappear, and the step defined by each island edge has been found to be more gradual. Subsequently, a first oxide layer is grown, followed by deposition and definition of polysilicon conductors, which are then implanted simultaneously with implantation of source and drain regions. Thereafter, a top oxide layer is deposited, contact openings are etched through the oxide layers followed by deposition and definition of aluminum conductors. The resulting step coverage of overlying aluminum conductors was found to be improved, the thickness of the aluminum conductors being uniform throughout the device, thereby solving the problem of discontinuities normally encountered in step coverage by the aluminum layer.

Brief Description of the Drawings

The invention is best understood by reference to the accompany drawings of which:

FIG. 1 is a simplified cross sectional view of a silicon-on-sapphire (SOS) island of the prior art over which a MOSFET is to be fabricated;

FIG. 2 is a partial top view of the SOS device of FIG. 1 after deposition of oxide layers and conductors;

FIG. 3 is a cross-sectional view of the silicon island of FIG. 2 taken along lines 3—3 of FIG. 2 and clearly showing the reduced insulation between a polysilicon conductor and the silicon island at the bottom edge corner of the island;

FIG. 4 is a cross-sectional view of the silicon island of FIG. 2 taken along lines 4—4 of FIG. 2 clearly showing the reduced thickness and poor step coverage of an aluminum conductor;

FIG. 5 is simplified cross-sectional view of an SOS island similar to that of FIG. 1, illustrating the application of an energy beam according to the method of the present invention;

FIG. 6 is a partial top view of the SOS device of FIG. 3 after application of the energy beam and after deposition of overlying oxide and metal layers;

FIG. 7 is a simplified cross-sectional view of the silicon island of FIG. 6 taken along lines 7—7 of FIG. 6 clearly showing the improved insulation between the polysilicon conductor and the silicon island at its bottom edge corner;

FIG. 8 is a simplified cross-sectional view of the silicon island of FIG. 6 taken along lines 8—8 of FIG. 6 clearly showing the improved step coverage of the aluminum conductor.

Detailed Description of the Invention

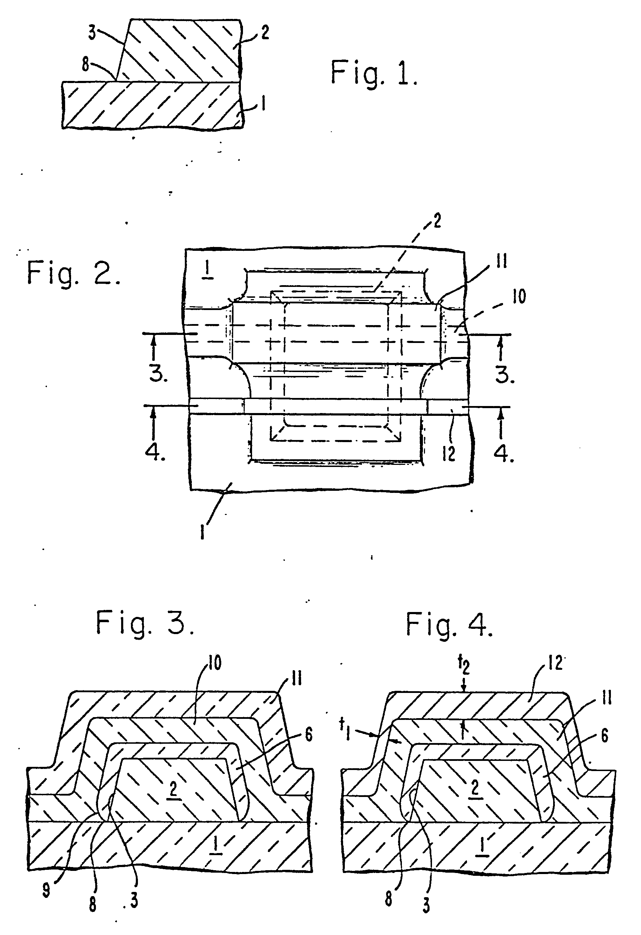

FIG. 1 is a simplified cross sectional view of a silicon on sapphire (SOS) island including a sapphire substrate 1 and a silicon island 2 photolithographically defined by an etching process to form an island edge 3. The island edge 3 has a steep slope created during definition of the silicon island 2.

Referring to FIG. 3, a first oxide layer 6 is preferably grown over the top surface of the silicon island 2 and the thickness of the oxide layer 6 is reduced at a bottom edge corner 8 of the island, forming a "V" shaped groove 9. Thereafter, a polysilicon conductor 10 shown in FIG.'s 2 and 3 is formed by deposition of polycrystalline silicon followed by photolithographic definition and etching. The deposited polysilicon fills the V-shaped groove 9 so that there is a significant likelihood of breakdown conduction between the polysilicon conductor 10 and the silicon island 2 in the vicinity of the V-shaped groove 9.

The polysilicon conductor 10 is deposited, photolithographically defined and etched. Thereafter, the device is ion implanted to render the polysilicon material conductive while simultaneously forming gatealigned source and drain diffusions in the silicon island 2, in a manner well known in the art. A second layer of oxide 11 is then placed over the device. Contacts (not shown) are defined through the oxide layers. An aluminium conductor 12 shown in Figures 2 and 4 is formed by evaporation followed by photolithographic definition and etching. Because the etching process which initially defines the edge 3 of the SOS island 2 shown in Figure 1 is not uniform, the resulting island edge 3 is rough.

Figure 4 clearly shows that the thickness $t_1$ of the aluminium conductor 12 deposited over the steep island edge 3 is significantly reduced with respect to the aluminium thickness $t_2$ overlying horizontal surfaces. This reduction of the thickness of the aluminium conductor 12 at the edge 3 increases the probability of discontinuities in the conductor 12. As a result, it has been found that the processing yield of metal-oxide-semi-conductor silicon-on-sapphire (MOS/SOS) devices is significantly reduced.

In the method of the present invention illustrated in Figure 5, a pulsed beam 13 or radiant energy is directed from an energy source 14 such as a laser toward the silicon island 2 prior to the growth or deposition of overlying insulating and conductive layers. The drawing of Figure 5 is purely schematic and does not imply any restriction on required beam size. The energy beam improves the quality of the crystal structure of the silicon island 2, which increases the channel mobility of metal oxide semiconductor field effect transistors (MOSFET's) fabricated on the silicon island 2. It should be noted that, in order to increase mobility, the energy beam may be applied either before or after definition of the silicon island 2. Mobility in MOS transistors is a well known concept in the art and is discussed, for example, in Penny, et al., *MOS Integrated Circuits*, Van Nostrand, Reinhold Co., 1972, pages 162-168, the disclosure of which is incorporated by reference. Referring to Figures 7 and 8, an oxide layer 6, a polysilicon conductor 10, a second oxide layer 11 and an aluminium conductor 12 are deposited in the manner described in connection with Figures 1 to 4.

If the energy beam is applied after definition of the silicon island 2, it causes reflow of silicon in the island edge 3, and the result is a reformed island edge 3' shown in solid line in Figure 5. The reformed island edge 3' has a moderate slope, being oriented at approximately 60° with respect to the top of the sapphire substrate 1.

Referring to Figure 8, the moderate slope of the island edge 3' permits the deposited aluminium conduction layer 12 to assume a nearly uniform thickness along the island edge, reducing the likelihood of physical discontinuities in the aluminium conductor 12.

Referring to Figure 7, the likelihood of breakdown conduction at the bottom edge corner 8 between the polysilicon conductor 6 and the silicon island 2 is significantly reduced because the V-shaped groove 9 is eliminated due to the reduced slope of the silicon island edge 3'.

In the preferred method of this invention, the energy beam source 14 of Figure 5 is a pulsed excimer laser, emitting a beam 13 having a pulse duration of approximately 25 nanoseconds, a wavelength of approximately 2490Å, and an energy density between 0.5 and 1.0 joule/cm². However, it should be recognized that the scope of this invention includes the use of any pulsed beam source, including an electron, ion or laser beam source in accordance with the present method. The method of this invention is applicable to any MOS/SOS structure similar to that of Figures 6, 7, and 8 in which the first insulating layer is any suitable dielectric, including grown silicon oxide, chemical vapor deposited silicon dioxide, grown silicon nitride, or grown silicon dioxide with chemical vapor deposited silicon nitride. The first insulating layer 6 may be grown or deposited silicon dioxide $Sio_2$ or silicon nitride $(Si_3N_4)$ of the type discussed by Pliskin, "Comparison of Properties of Dielectric Films Deposited by Various Methods", *Journal of Vacuum Science Technology*, Vol. 14, No. 5, September/October 1977, pp. 1064-1081.

The first conductive layer 10 may be any polycrystalline or amorphous material, such as polycrystalline silicon or it may be polycide or metal silicide of the type disclosed in Crowder et al, "Ium MOSFET VLSI Technology: Part VII Metal Silicide Interconnection Technology A Future Prospective", IEEE Trans. on Electron Devices, Vol. Ed.-26 No. 4, April 1979, pages 369-371. Alternatively, the conductive layer 10 may also be a refractory metal layer of the type disclosed in Shah, "Refractory Metal Gate Processes for VLSI Applications", IEEE Trans. on Electron Devices, Vol. ED-26, No. 4, April 1979, pp 631-640. The disclosures of the above-identified Crowder, Shah, and Pliskin Publications are hereby expressly incorporated herein by reference in their entirety.

In summary, this invention is a unique processing technique for improving silicon on sapphire device performance by improving the crystal structure of the silicon islands surface layer to increase channel mobility and thereby improve device operating speed.

## Claims

1. A method for increasing channel carrier mobility in a surface region of a silicon island (2) formed on a sapphire substrate (1) comprising irradiating a predetermined surface area of the silicon island with a pulsed radiation beam (13) of a chosen wavelength, pulse duration and energy per unit area sufficient to elevate the temperature of only a thin surface layer bounded by said surface area to the melting point of the silicon, and thereafter allowing the silicon to cool below its melting point while recrystallizing to solid state.

2. A method according to claim 1 wherein the radiation beam is a laser beam.

3. A method according to claim 2, wherein the irradiating beam is from a excimer laser having pulse duration of approximately 25 nanoseconds, a wavelength of approximately 2490 angstroms and an energy density between 0.5 and 1.0 joule per centimeter squared.

4. A method according to claim 1 wherein said radiation beam comprises an electron beam.

5. A method according to claim 1 wherein said radiation beam comprises an ion beam.

## Patentansprüche

1. Ein Verfahren zum Erhöhen der Kanal-Carrierbeweglichkeit in einem Oberflächenbereich einer Siliziuminsel (2), welche auf einem Saphirsubstrat (1) gebildet wird, die folgenden Schritte umfassend:

Bestrahlen eines vorbestimmten Oberflächenbereiches der Siliziuminsel mit einem gepulsten Strahlungsstrahl (13) mit einer ausgewählten Wellenlänge, Impulsdauer und Energie pro Einheitsfläche, die ausreicht, die Temperatur einer nur dünnen Oberflächenschicht, die durch den Oberflächenbereich begrenzt wird, auf den Schmelzpunkt des Siliziums anzuheben und man dem Silizium anschließend erlaubt, unter seinen Schmelzpunkt abzukühlen, wobei es wieder in den festen Zustand kristrallisiert.

2. Ein Verfahren nach Anspruch 1, wobei der Strahlungsstrahl ein Laserstrahl ist.

3. Ein Verfahren nach Anspruch 2, wobei der Strahlungsstrahl aus einem Excimerlaser mit einer Impulsdauer von etwa 25 Nanosekunden, einer Wellenlänge von etwa 2490 Angström und einer Energiedichte zwischen 0,5 und 1,0 Joule pro Quadratzentimeter stammt.

4. Ein Verfahren nach Anspruch 1, wobei der Strahlungsstrahl einen Elektronenstrahl umfaßt.

5. Ein Verfahren nach Anspruch 1, wobei der Strahlungsstrahl einen Ionenstrahl umfaßt.

## Revendications

1. Procédé pour augmenter la mobilité des porteurs dans le canal dans une région de surface d'un îlot de silicium (2) formé sur un substrat de saphir (1) comprenant une irradiation d'une aire de surface prédéterminée de l'îlot de silicum avec un faisceau de rayonnement par impulsions (13) ayant une longueur d'onde, une durée d'impulsion et une énergie par unité d'aire suffisantes pour élever la température seulement d'une couche mince de surface délimitée par ladite aire de surface jusqu'au point de fusion du silicium après quoi on laisse le silicium se refroidir au-dessous de son point de fusion en se recristallisant à l'état solide.

2. Procédé conforme à la revendication 1, dans lequel le faisceau de rayonnement est un faisceau laser.

3. Procédé conformé à la revendication 2, dans lequel le faisceau d'irradiation provient d'un laser excimère ayant une durée d'impulsion d'environ 25 nanosecondes, une longueur d'one d'environ 2490 angströms et une densité d'énergie entre 0,5 et 1,0 joule par centimétre carré.

4. Procédé conforme à la revendication 1, dans lequel ledit faisceau de rayonnement comprend un faisceau d'électrons.

5. Procédé conforme à la revendication 1, dans lequel ledit faisceau de rayonnement comprend un faisceau d'ions.

Fig. 1.

Fig. 2.

Fig. 3.

Fig. 4.